# EUROPEAN PATENT APPLICATION

(11) **EP 1 508 913 A1**
(43) Date of publication of application: **23.02.2005**
(21) Application number: 03730693.3
(22) Date of filing: 29.05.2003
(51) Int. Cl.: H01L 21/316, C01B 33/12, H01L 21/768

(54) **METHOD FOR FORMING INORGANIC POROUS FILM**

(30) Priority: 30.05.2002 JP 2002157467
(71) Applicant: Semiconductor Leading Edge Technologies, Inc., Ibaraki 305-8569 (JP)
(72) Inventor: OGAWA, S., Semiconductor Leading Edge Tech., Inc., Tsukuba-shi, Ibaraki 305-8569 (JP); NASUNO, T., Semiconductor Leading Edge Tech., Inc., Tsukuba-shi, Ibaraki 305-8569 (JP); KAJI, N., Semiconductor Leading Edge Techn., Inc., Tsukuba-shi, Ibaraki 305-8569 (JP)
(74) Representative: Hofer, Dorothea, Dipl.-Phys.
(86) International application number: PCT/JP2003/006736
(87) International publication number: WO 2003/103034

(57) **Abstract**

A method for forming an inorganic porous film comprises the steps of applying, onto a support, an inorganic material composition wherein a silicon oxide precursor containing at least one hydrolyzable silane compound and a pore-generating material are mixed, thereby forming a film, drying the film, contacting the film after the drying with a supercritical fluid to remove the pore-generating material; and baking the film after the removal of the pore-generating material.

## Description

### Technical Field

This invention relates to a method for forming an inorganic porous film. More particularly, the invention relates to a method for forming an inorganic porous film of low dielectric property adapted for use in semiconductor devices.

### Background Art

According with the miniaturization and speeding up of semiconductor devices, wiring structures are running toward multilayered ones. With advance in such miniaturization, speeding-up and multilayered structures, there arises a problem on signal delay owing to increased wiring resistance and parasitic capacitances between wiring lines and also between wiring layers. Since signal delay T is proportional to the product of wiring resistance R and parasitic capacitance C, it is necessary to render the wiring layers not only low in resistance, but also small in parasitic capacitance in order to make signal delay T smaller.

To reduce wiring resistance R, it is an advantage to use a wiring material having a lower resistance. More particularly, examples of the wiring resistance reduction include the change from conventional aluminium (Al) wiring to copper (Cu) wiring.

On the other hand, the parasitic capacitance C between wiring layers has the relation of C = (ε·S)/d wherein ε is a relative dielectric constant of an interlayer insulating film provided between the wiring layers, d is a space between the wiring layers, and S is a lateral area of the wiring layers. Accordingly, in order to reduce the parasitic capacitance C, it is necessary to reduce the dielectric constant of the interlayer insulating film.

A interlayer insulating film hitherto known, for example, is a film which is formed from a sol obtained by hydrolysis of tetraalkoxysilane, by an SOG (spin on glass) method. However, this interlayer insulating film has a three-dimensional network structure constituted mainly by siloxane bond (-Si -O -Si) and has a relative dielectric constant as high as about 4.0. Moreover, organic materials such as polyarylether derivatives, and organic SOG films in which an organic group such as methyl group (-CH₃) is introduced into silicon dioxide (SiO₂) to realize a low density, thereby lowering relative dielectric constant are also known. However, the relative dielectric constants of these materials are about 2.6 to 2.9, so that a further lowering of the relative dielectric constant has been demanded for next-generation semiconductor devices having a more miniaturized design rule.

To further lowering the relative dielectric constant of interlayer insulating film, it is proposed to make a porous film. This intends to lower the relative dielectric constant not through chemical formulation of the film, but through physical structure thereof. In a porous insulating film, it becomes possible to realize a lower relative dielectric constant at a larger pore content inside the film. In general, a porous film is formed by applying, onto a substrate, an insulating film material to which an appropriate type of pore-generating material is added, followed by thermal treatment to decompose and evaporate the pore-generating material, thereby creating pores in the film inside.

However, the thermal treatment for carrying out the decomposition and evaporation of the pore-generating material simultaneously causes the polymerization of the insulating film material to proceed, with the possibility that a vaporized pore-generating material is confined within the crosslinked structure of the resultant polymer. Although the pore-generating material is in the form of fine particles on the scale of nanometer, a confined gas escapes to outside of the film while involving a small explosion. This results in the pores having sizes that are larger than the particle size of the pore-generating material and become irregular. At the same time, the crosslinking bonds around the pores are broken, thereby giving physical damages on the polymer. This method has raised a problem of deterioration of mechanical characteristics of a film such as Young's modulus, hardness and the like. Another problem has also been encountered in that in order to restore the mechanical characteristics, the temperature of thermal treatment carried out in a subsequent step has to be elevated.

The invention has been accomplished in light of these problems. More particularly, the invention has for its object the provision of a method for forming an inorganic porous film of low dielectric property which has pores whose size is uniform and has good mechanical characteristics.

The invention also has as its object the provision of a method for forming an inorganic porous film of low dielectric property wherein a thermal treating temperature can be lowered.

Other and advantages of the invention will become apparent from the following description.

### Disclosure of the Invention

The method for forming an inorganic porous film according to the invention comprises the steps of applying, onto a support, an inorganic material composition wherein a silicon oxide precursor containing at least one hydrolyzable silane compound, a pore-generating material and solvent are mixed, thereby forming a film, drying the film, contacting the dried film with a supercritical fluid to remove the pore-generating material, and baking the film after the removal of the pore-generating material.

In this manner, pores can be formed without resorting to thermal decomposition of the pore-generating material, so that an inorganic porous film of low dielectric property that has pores whose size is uniform and has good mechanical characteristics can be formed. In addition, the thermal treating temperature can be lowered over conventionally employed ones.

### Brief Description of the Drawings

Figs. 1(a) to 1(d) are schematic views illustrating a method of forming an insulating film according to the invention.
Fig. 2 shows an example of the results of measurement of profile along the direction of depth of a ratio between carbon and silicon of the films formed in Example and Comparative Example 1.
Fig. 3 shows an example of the results of measurement of dielectric constant of the films formed in Example and Comparative Example 1.
Fig. 4 shows an example of the results of measurement of Young's modulus of the films formed in Example and Comparative Example 2.
Fig. 5 shows an example of the results of measurement of hardness of the films formed in Example and Comparative Example 2.
Fig. 6 shows an example of the results of measurement of pore size distribution of the films formed in Example and Comparative Example 2.

### Detailed Description of the Preferred Embodiments

Embodiments of the invention are described in detail with reference to the drawings.

The invention is characterized in that an inorganic material composition containing a template that is made of fine particles on the scale of nanometer for use as a pore-generating material is applied onto a substrate and dried to form a film, after which the template is dissolved out by use of a supercritical fluid, thereby rendering the resulting insulating film porous. The supercritical fluid used herein means a fluid which is placed under temperature and pressure conditions not lower than critical points of substance. The fluid in this condition has the capability of dissolution similar to that of liquid and also has a diffusion property and viscosity close to gas. Moreover, no surface tension occurs at fine interstices and thus, a capillary phenomenon can be suppressed, so that a specified type of substance can be extracted and removed from a fine structure. Accordingly, if a supercritical fluid is used, the template entering into fine interstices among molecules can be removed to form pores without thermal decomposition of the template.

Initially, an insulating inorganic material composition is prepared. More particularly, a silicon oxide precursor containing at least one hydrolyzable silane compound and a template agent as a pore-generating material are mixed with solvent. For instance, the template agent is added, in a given amount, to a solution wherein an alkoxysilane such as TEOS (tetraethoxysilane), TMOS (tetramethoxysilane) or the like and water are mixed with ethanol. The hydrolyzable silane compound may be those compounds which are able to provide silica through polycondensation by hydrolysis, and several types of silane compounds may be mixed. For examples of template agents include an organic template having one or more functional groups, such as an amino group, at a terminal or inside thereof. The particle size of the template agent is preferably 10 nm or below. The solvent may be any one which is suited for forming a film on a semiconductor substrate, and should not be construed as limiting to the above-indicated ethanol.

The inorganic material composition may further comprise components other than those defined above. For instance, a catalyst such as hydrochloric acid or the like, and other additive such as a surfactant may be added.

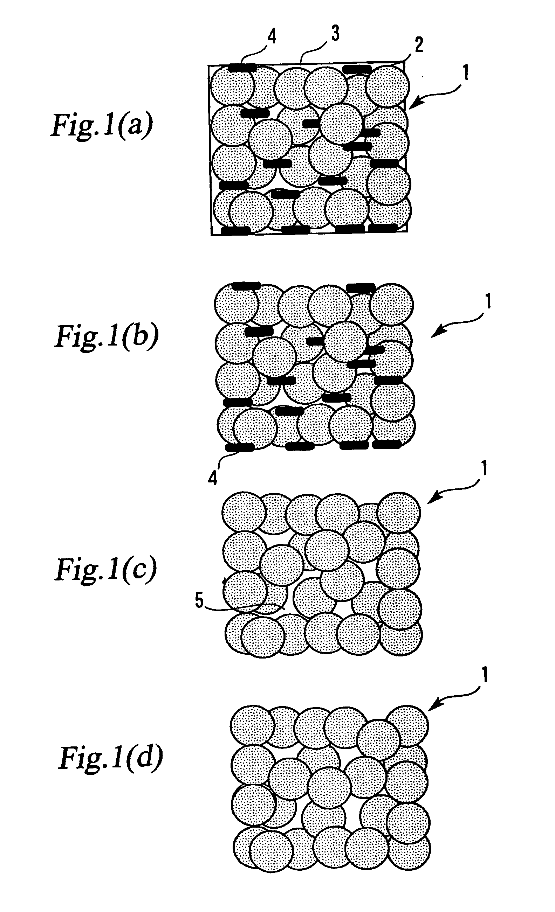

Next, the inorganic material composition is applied onto a semiconductor substrate. For example, a silicon substrate is provided as the semiconductor substrate, applying the inorganic material on the substrate by use of a spinner. The film thickness can be, for example, at about 500 nm. Figs. 1 (a) to 1(d) are schematic views illustrating the method of forming a insulating film according to the present invention. As shown in Fig. 1(a), molecules 2 in the inorganic material composition 1 formed on a semiconductor substrate forms clusters as having such a structure that the molecules 2 and a template 4 entering in between the molecules 2 are dispersed in a solvent 3.

Next, drying is carried out by thermal treatment (pre-baking) to remove the solvent from the inorganic material composition. For instance, the semiconductor substrate applied thereon with the inorganic material composition is placed in an oven and thermally treated. The temperature of the thermal treatment may be a level at which the solvent is removable, but should be a temperature which is lower than the decomposition and evaporation temperatures of the template. More particularly, the temperature is preferably in the range of 100°C to 250°C. In this way, the solvent is evaporated off, thereby enabling one to remove the solvent from the inorganic material composition. On the other hand, although it may occur to one that the polymerization reaction of molecules proceeds to an extent in the course of the thermal treatment, the decomposition and evaporation reactions of the template do not occur, so that any template is not removed. In other words, as shown in Fig. 1(b), the template 4 is left in the film as entering in the interstices formed between the molecules 2.

Thereafter, the semiconductor substrate is brought into contact with a supercritical fluid. The contact may be performed, for example, by immersing the semiconductor substrate in the supercritical fluid. The temperature and the pressure of the supercritical fluid may be at levels respectively not lower than the critical temperature and not lower than the critical pressure. The supercritical fluids usable in the present invention include, for example, hydrocarbons such as methane, ethane, propane, butane, benzene and the like, alcohols such as methanol, ethanol, propanol and the like, ketones such as acetone, methyl ethyl ketone and the like, ethers such as diethyl ether and the like, carbon dioxide, carbon monoxide, and the like. These may be used singly and may also be used in combination.

The supercritical fluid used in the invention is most preferably carbon dioxide from the standpoint that the supercritical temperature is low, with ease in handling and inexpensiveness. Using carbon dioxide, the temperature is preferably in the range of room temperature (25°C) to 100°C, and the pressure is preferably in the range of 10 MPa to 100 MPa. When an alcohol such as isopropyl alcohol is mixed with carbon dioxide, the solubility of the template is increased, thereby the template is able to remove more completely.

When the semiconductor substrate touches a supercritical fluid, the supercritical fluid infiltrates into fine interstices existing among the molecules in the film formed on the semiconductor substrate, and dissolves out the template entering in the interstices. Thus, as shown in Fig. 1(c), the template is removed from among the molecules, thereby pores 5 are formed at portions where the template exists. At this stage, it is considered that crosslinking bonds are formed among the molecules to an extent owing to the polymerization reaction through the afore-mentioned pre-baking. Nevertheless, the template is not removed from the molecules as a result of the decomposition and evaporation reactions, but is removed by dissolution in the supercritical fluid. Eventually, when the template entering in the interstices among the molecules escapes to outside of the molecules, the intermolecular bonds are not broken. The pores left after the escape of the template have a size corresponding to the size of the template, and thus a larger pore size will not be formed due to the removal of the template.

After the removal of the template, in order that the polymerization reaction of the molecules is allowed to proceed to form a three-dimensional crosslinking structure, anther thermal treatment (post-baking) at higher temperatures is carried out to bake the film. The heating is performed, for example, by placing the semiconductor substrate in an oven. The treating conditions is preferably a temperature of 350°C to 400°C and a time of 10 minutes to 30 minutes. When the post-baking is carried out, a vitreous inorganic porous film having pores in the molecules are formed as shown in Fig. 1(d).

In this embodiment, an instance of forming an inorganic porous film on a semiconductor substrate has been stated, to which the invention should not be construed as limitation thereof. In applications where a film of low dielectric property is required, formation on other types of support substrate may be possible.

### Example

A coating composition (commercial name of IPS) wherein a template was mixed with a commercially available silica (SiO₂) component was spin coated onto a silicon substrate by means of a spinner. Next, according to the embodiment of the invention, a film subjected to pre-baking at a temperature of 150°C to 250°C was immersed in carbon dioxide, which was under supercritical conditions of a temperature of 80°C and a pressure of 15 MPa, over 120 minutes to carry out pore-generating treatment, followed by post-baking at 350°C or 400°C.

### Comparative Example 1

A coating composition (commercial name of IPS) wherein a template was mixed with commercially available silica (SiO₂) component was spin coated onto a silicon substrate by means of a spinner. Next, after pre-baking at 150°C, post-baking was carried out at 400°C without pore-generating treatment.

### Comparative Example 2

A coating composition (commercial name of IPS) wherein a template was mixed with commercially available silica (SiO₂) component was spin coated onto a silicon substrate by means of a spinner. Next, thermal treatment at 250°C was carried out to cause the template to be decomposed and evaporated for pore generation, followed by post-baking at 350°C or 400°C.

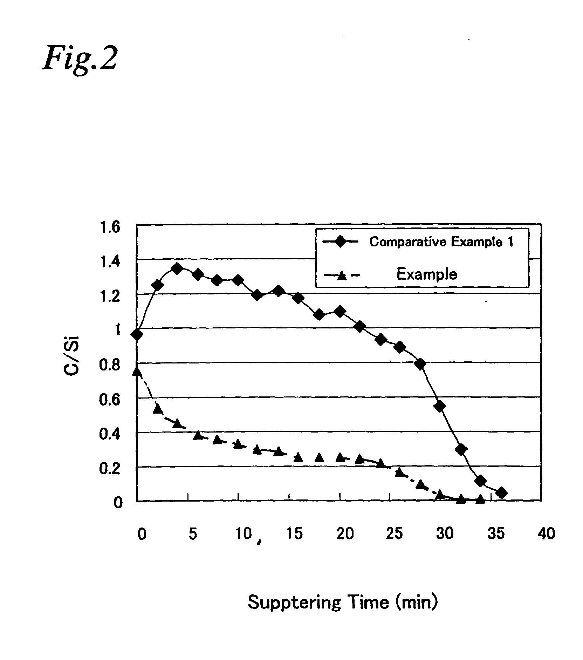

Fig. 2 shows an example of the results of measurement of a profile along the depth of a carbon to silicon ratio (C/Si value) by use of secondary ion mass spectroscopy of the films formed in Example and Comparative Example 1. It will be noted that immersion in a supercritical fluid is hereinafter referred to simply as SCF treatment.

As will be apparent from the figure, the C/Si value of the film subjected to the SCF treatment is smaller than that of the film not subjected to the SCF treatment. Since the inorganic polymers used as base are the same, the above results reveal that the content of carbon in the film subjected to the SCF treatment is smaller. On the other hand, carbon is a main component of the template. Accordingly, it will be appreciated that the template is removed from the film when the SCF treatment is carried out.

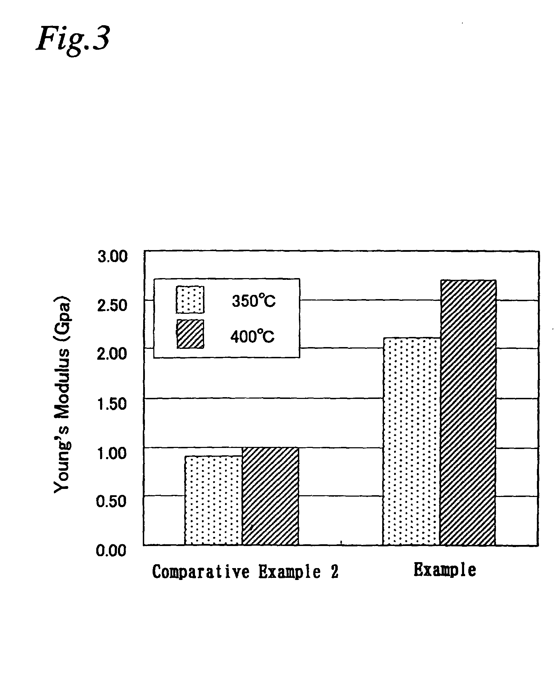

Fig. 3 shows an instance of the results of measurement of dielectric constant of the films formed in Example and the Comparative Example 1. The measurement was made according to a mercury probe method. From the figure, with the SOG film subjected to the SCF treatment, the dielectric constant is lowered by about 10% when compared with the SOG film not subjected to the SCF treatment.

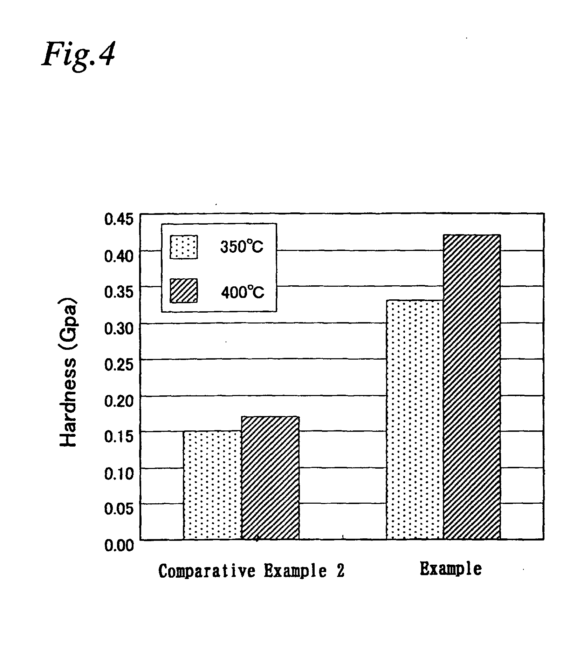

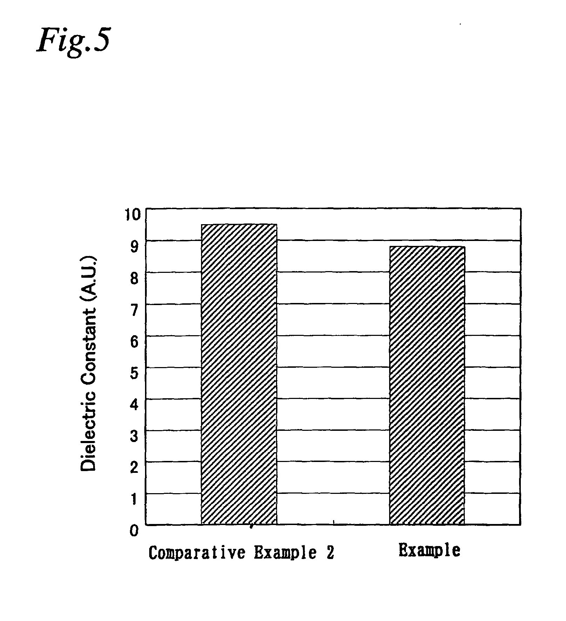

Figs. 4 and 5, respectively, show examples of the results of measurements of Young's modulus and hardness of the films formed in Example and Comparative Example 2 for different post-baking temperatures. The measurements were, respectively, made according to a nano indent method. These results reveal that when the SCF treatment is carried out, the young's modulus and hardness, respectively, become higher by 2.5 times or over than those of the case where no SCF treatment is carried out. Moreover, the porous film (Example) which was thermally treatment at 350°C and was subjected to the SCF treatment has Young's modulus and hardness higher by 2 times or over than the conventional porous film (Comparative Example 2) thermally treated at 400°C and not subjected to the SCF treatment. Accordingly, when the SCF treatment of the invention is carried out, the temperature of the post-baking can be further lowered from 350°C.

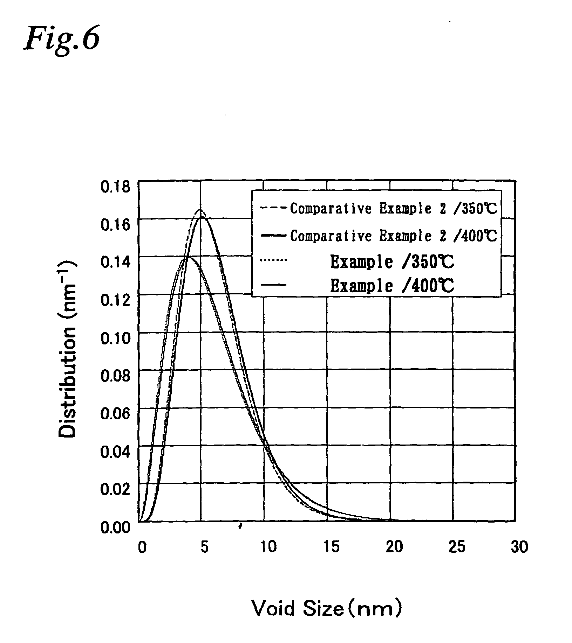

Fig. 6 shows an example of a pore size distribution of the films formed in Example and Comparative Example 2, which was measured by changing the post-baking temperature. The measurement was made according to an X-ray diffuse scattering methods. As will be seen from the figure, the pore size exhibiting the maximum distribution frequency is at about 3 nm in the case where the SCF treatment was carried out and at about 5 nm where no SCF treatment was carried out. Where the thermal treatment was carried out at 350°C, the average pore size is at 5.90 nm under SCF treating conditions and at 6.06 nm under no SCF treating conditions. In addition, where the thermal treatment was carried out at 400°C, the average pore size is at 6.00 nm under SCF treating conditions and at 6.27 nm under no SCF treating conditions. From these results, it will be seen that the pores formed after subjecting to the SCF treatment are smaller than those pores formed by the conventional thermal treatment as a whole.

### Industrial Applicability

As stated hereinbefore, the method for forming an inorganic porous film according to the present invention can form pores by use of a supercritical fluid without thermal decomposition of a template, thus ensuring the formation of an inorganic porous film of low dielectric property having a uniform pore size and good mechanical characteristics. In addition, the post-baking temperature can be made lower than that conventionally employed.

## Claims

1. A method for forming an inorganic porous film comprising the steps of:
applying an inorganic material composition wherein a silicon oxide precursor containing at least one hydrolyzable silane compound, a pore-generating material and solvent are mixed, on a support to form a film;
drying said film;
contacting said film after the drying with a supercritical fluid to remove said pore-generating material; and
baking said film after the removal of said pore-generating material.

2. The method for forming an inorganic porous film according to claim 1, wherein said supercritical fluid is made of at least one selected from the group consisting of hydrocarbons, alcohols, ketones, ethers, carbon dioxide and carbon monoxide.

3. The method for forming an inorganic porous film according to claim 1 or 2, wherein said supercritical fluid consists of carbon dioxide of a temperature of 25°C to 100°C and a pressure of 10 MPa to 100 MPa.

4. The method for forming an inorganic porous film according to claims 1 to 3, wherein said support is a semiconductor substrate, and said inorganic porous film is an interlayer insulating film.
